**Europäisches Patentamt**

**European Patent Office**

**Office européen des brevets**

(19)

(11) Publication number: **0 164 921**
**A2**

(12)

# EUROPEAN PATENT APPLICATION

(21) Application number: **85303436.1**

(22) Date of filing: **16.05.85**

(51) Int. Cl.⁴: **H 05 K 3/12**
**H 05 K 3/46**

(30) Priority: **17.05.84 GB 8412606**

(43) Date of publication of application:
**18.12.85 Bulletin 85/51**

(84) Designated Contracting States:
**AT BE CH DE FR GB IT LI LU NL SE**

(71) Applicant: **Murray, John**
**55 Granville Park**
**Aughton Lancashire(GB)**

(72) Inventor: **Murray, John**
**55 Granville Park**
**Aughton Lancashire(GB)**

(74) Representative: **Huntingford, David Ian et al,**
**W.P. THOMPSON & CO. Coopers Building Church Street**
**Liverpool L1 3AB(GB)**

(54) **Improvements in and relating to printed circuit boards.**

(57) A single or multi-layer circuit board is formed by printing directly onto an electrically non-conductive medium using a metal-based fluid which, upon drying, leaves behind a solid metallic residue defining a predetermined circuit configuration. For multi-layer boards a plurality of conductive and non-conductive layers are printed alternately onto a non-conductive substrate or onto a conductive substrate provided with a non-conductive surface.

Fig 1.

EP 0 164 921 A2

## DESCRIPTION

## IMPROVEMENTS IN AND RELATING TO PRINTED CIRCUIT BOARDS

The present invention is concerned with printed circuit boards and their manufacture.

Known types of single layer printed circuit board comprise an electrically non-conducting substrate onto which is fixed an electrically conducting medium, such as copper, in the form of a pattern defining a circuit configuration. Holes are drilled through the copper and substrate to allow the circuit components to be fixed thereto, for example by means of soldering.

During formation of such boards, the substrate initially has one side covered with copper. In order to leave the required conductive pattern on the substrate, an etchant-resistant medium, such as an ink, is applied over those parts of the copper which are to form the pattern. The board is then placed in an etchant, such as ferric chloride, which etches away those parts of the copper which are not covered by the etchant-resistant ink, thus leaving the desired pattern of copper on the substrate.

Known multi-layer printed circuit boards are made in the same way, except that a plurality of boards are placed one above the other and have holes in the same location on each board for fixing circuit components and for connecting each board together electrically, for example by means of soldering.

It is one object of the present invention to provide a single-layer printed circuit board which is cheaper and simpler to produce than conventional single-layer printed circuit boards.

It is another object of the present invention to provide a method of manufacturing such circuit boards.

-2-

It is a further object of the present invention to provide a multi-layer printed circuit board which is cheaper and simpler to produce than conventional multi-layer printed circuit boards.

It is a still further object of the present invention to provide a method of manufacturing such circuit boards.

In accordance with one aspect of the present invention there is provided a single layer printed circuit board comprising a non-conducting substrate onto which is printed a layer of conducting medium in the shape of a predetermined circuit configuration.

In accordance with another aspect of the present invention there is provided a method of manufacturing a single-layer printed circuit board comprising printing a layer of conducting medium onto a non-conducting substrate, said conducting medium being in the shape of a predetermined circuit configuration.

In accordance with a further aspect of the present invention there is provided a multi-layer printed circuit board comprising a non-conducting substrate onto which is printed a conducting medium and a non-conducting medium alternately in layers, there being at least two conducting layers and at least one non-conducting layer, said at least two conducting layers being in the shape of predetermined circuit configurations, and said at least one conducting layer having openings therein to allow access between the conducting layers in a predetermined manner.

In accordance with a still further aspect of the present invention there is provided a method of manufacturing a multi-layer printed circuit board comprising printing a conducting medium alternately in layers onto a non-conducting substrate, there being at least two conducting layers and at least one non-conducting layer, said at least two conducting layers being in the shape of predetermined circuit configurations and said at least one non-conducting layer having openings therein to allow access between the conducting layers in a predetermined manner.

In a preferred embodiment, the conducting medium is in the form of a metal based fluid, for example based on copper, silver, gold, aluminium or other conductive materials. The fluid is chosen so that at least part of the fluid evaporates, leaving behind a solid metallic residue.

The non-conducting layers of the multi-layer circuit board can be in the form of a commercially available non-conducting varnish or a combination of varnish and other electrically non-conducting materials.

In the multi-layer printed circuit board of the present invention it is possible to connect circuit components onto different conduction layers. This allows a reduction in the size of the board required.

An advantage of the present invention over known types of printed circuit board is that no etching of the conducting medium is required. This considerably simplifies their manufacture and makes them cheaper to make.

The invention is described further hereinafter, by way of example only, with reference to the accompanying drawings, in which:

Fig.1 is an exploded schematic view of one embodiment of a multi-layer printed circuit board in accordance with the present invention;

Fig.2 is a schematic plan view illustrating how the tracks on the various layers of the multi-layer board are interconnected; and

-4-

Fig.3 is a schematic side view illustrating one means of printing the conductive ink in the manufacture of a printed-circuit board in accordance with this invention.

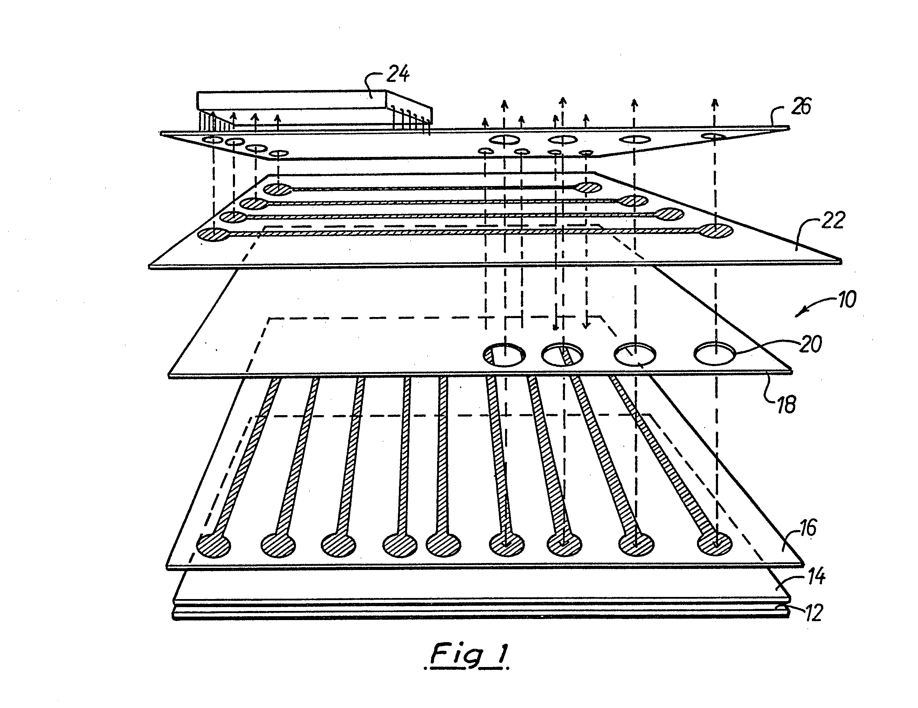

Referring first to Fig.1 a multi-layer board 10 has a substrate 12. Substrate 12 can be a layer of an electrically non-conductive material, such as a non-conductive board as used for conventional printed circuit boards. Alternatively, the substrate can be made of an electrically conductive material, for example a convenient metal. In the latter case in particular, the copper surface of the substrate 12 is rendered electrically non-conductive by the application thereto of an electrically non-conductive insulation layer 14, for example a suitable varnish. As described below, the substrate can in some circumstances be formed of a solid layer of an electrically conductive material, such as gold, which serves to carry power to the circuit components. Particularly in the latter case, the substrate should preferably be a good conductor of heat to dissipate the heat generated in the circuit.

The substrate can thus be formed from a wide variety of materials, for example aluminium, mild steel, cloth, acetate film, glass paper and plasticised paper.

Multi-layer circuit boards are used for constructing complex circuits. To this end, multiple layers of predetermined circuit configurations are connected together to form whole circuits. In Fig.1, a conducting track layer 16 represents a pattern of a predetermined circuit configuration. Layer 16 is printed onto the insulation layer 14, or directly onto the substrate 12 if the latter is non-conductive, in a manner described further hereinafter. The conducting medium used for track layer 16 is a fluid based on a metal such as copper, silver, gold or aluminium, part of which evaporates to leave a conductive metallic circuit on the insulated substrate 12.

A non-conducting insulation layer 18, for example of a suitable varnish, is then printed onto track layer 16 in order to electrically isolate layer 16 from subsequent conducting layers. The connections that are required between conducting layer 16 and subsequent conducting layers are made via openings 20 in the layer of varnish 18. These openings 20 then form contact points for such connections. Such openings 20 may also be used for connecting circuit components to various conducting layers.

Fig.1 shows a further conducting track layer 22 printed onto the layer of varnish 18 to complete the circuit configuration. Depending on the requirements of particular circuits, any number of conducting layers and non-conducting layers may be sandwiched together.

In order to complete the circuit, components such as indicated by reference numeral 24 are fixed onto the conducting layers on the board. A further insulation layer 26 can be applied over the track layer 22 when necessary. Conventional components 24 may be used, but this requires drilling through the board. Alternatively, surface mounted components may be used which stick directly onto the top layer 22 (or 26), thus obviating the need for drilling.

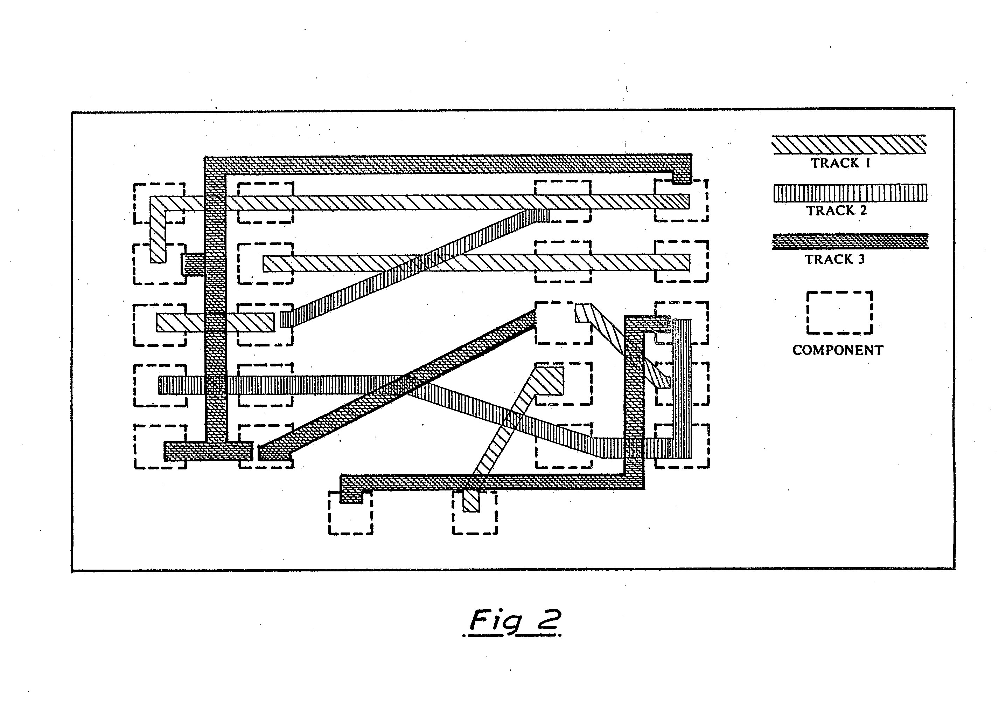

Fig.2 illustrates how tracks on three different conductive layers might be interconnected with components to complete the circuit on the board.

In the case of a single-layer printed circuit board, only the substrate 12 and the first conducting track layer 16 are essential, although non-conducting insulation layers corresponding to layers 14 and 18 can be included where appropriate.

As well as conventional components on the board, it is also possible to incorporate components into the actual individual layers. For example, resistors can be incorporated into the conductive track layer thus saving space on the outer parts of the board.

A reduction in the required board size over conventional boards is also achieved because components are able to connect to different layers and it is, therefore, not necessary to have all the contact points on the surface layer.

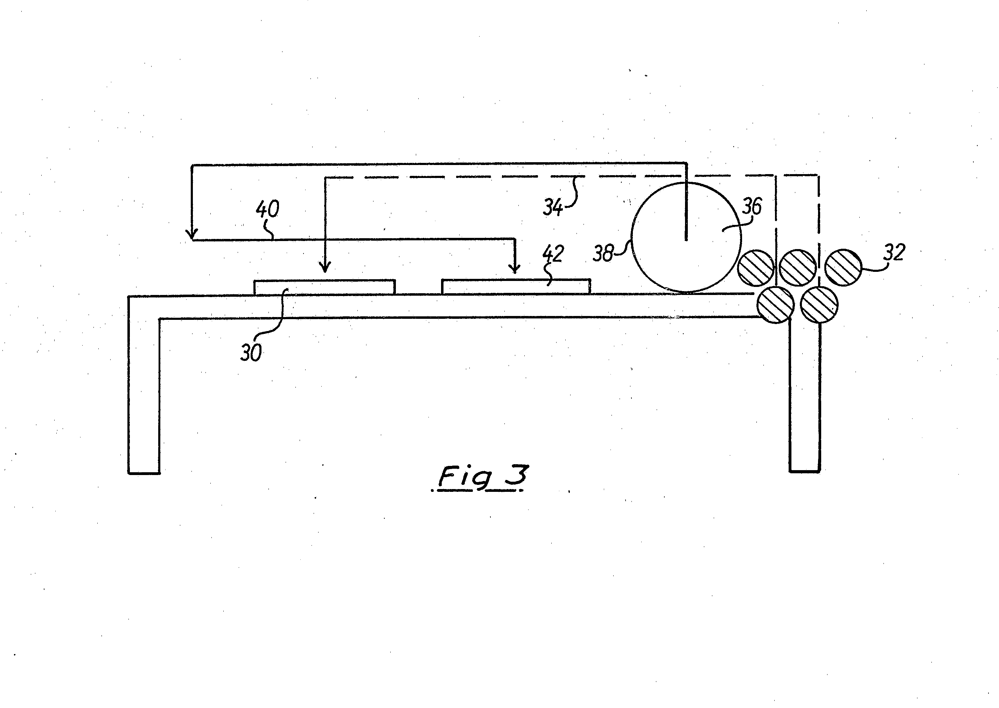

A printing technique suitable for printing the conducting and non-conducting layers is now described with reference to Fig.3.

The technique comprises taking a photographic negative of the required circuit configuration. From this a plastics printing plate 30 is produced wherein the pattern of the circuit is in slight relief from the rest of the surface of the plate.

The conducting medium containing the metallic element is then applied from rubber rollers 32 to the plate 30 by displacing the rollers 32 over the plate 30 as indicated by the chain line 34 in Fig.3. The image is then transferred to a cylinder 36 which is covered in a rubber sheet or blanket 38 by rolling the cylinder over the plate 30 as indicated by solid line 40 in Fig.3. The rubber picks up a perfect image from the printing plate 30 and transfers this to the substrate 42 (corresponding, for example, to substrate 12 or insulation layer 14 of Fig.1). The conducting medium is then dried.

A plastics plate can be produced in a similar manner for each non-conducting layer and for each subsequent conducting layer. The layer of varnish is similarly printed over the dry conducting layer on the substrate. Subsequent conducting layers and non-conducting layers are then applied to the board in the same manner until the circuit board is completed. Suitable varnishes are presently available commercially.

By way of example, the conducting medium itself can be a mixture of silver and two separate varnishes. The latter varnishes are selected such that, when the conducting medium is dried by the application of heat, one varnish evaporates and the other oxidises and binds the flaked and/or powdered particles of silver into a solid layer.

In some types of multi-layer board, the non-conducting varnish may have to contain powdered glass or such substance, and after the final application the board would be heated until the varnish material sintered or melted into a glazed surface.

An alternative layer arrangement for the board is as follows. A suitable non-conductive substrate is chosen, such as aluminium oxide, and a conductive layer is then put down on top of this substrate, the conductive layer being a relatively thick, solid layer of a metal such as gold, which can then be used to carry power (as compared to low energy signals) to operate all components. Non-conductive and conductive track layers are then applied to this solid conductive layer as before. Thus, in this type of board, the conductive tracks are used only for carrying signals which require low power. The tracks can therefore then be of minimum width and thickness.

Another advantage of the present technique is that it enables the circuitry to be applied directly to the body or housing of an item of equipment to be controlled. For example, in the case of a toy doll which has a plastics body and which is to incorporate some form of electronic control, the circuitry can be printed directly onto the plastics body so that the body itself serves as the substrate 12. It is then no longer necessary to provide a separate substrate, the electronic components being mounted directly onto the body or other housing part onto which the basic circuit has been printed.

. . . . . . . . . . . . . . . . . . . . . . . . . . . . . . . . . . . . . . . . . . . . . . . . . . . . . . . .

CLAIMS

1. A single layer printed circuit board comprising an electrically non-conductive layer carrying an electrically conductive medium in the form of a pattern defining a predetermined circuit configuration, characterised in that the conducting medium is printed onto the electrically non-conductive medium in the form of a metal-based fluid which, upon drying, leaves behind a solid metallic residue defining said predetermined circuit configuration.

2. A printed circuit board as claimed in claim 1, wherein the electrically non-conductive layer is carried by a metal substrate.

3. A method of manufacturing a single-layer printed circuit board of the type comprising an electrically non-conductive medium carrying an electrically conductive medium in the form of a pattern defining a predetermined circuit configuration, characterised in that the conducting medium is printed directly onto the electrically non-conductive medium in the form of a metal-based fluid and the metal based fluid is then dried, the metal-based fluid being chosen such that, upon drying, it leaves behind on said non-conductive medium a solid metallic residue defining said predetermined circuit configuration.

4. A multi-layer printed circuit board in which at least two layers of an electrically conductive medium are separated by an electrically non-conductive medium, said two conductive medium layers defining respective predetermined circuit patterns, characterised in that the board comprises an electrically non-conductive layer onto which is printed a conducting medium and a non-conducting medium alternately in layers, the conducting medium in each case being printed directly onto a respective non-conductive layer in the form of a metal-based fluid which, upon drying, leaves behind a solid metallic residue on that non-conductive layer to define a respective predetermined circuit configuration.

5. A multi-layer circuit board wherein discrete components are mounted on a top surface of the board and are connected to two or more conductive layers via holes in said non-conductive layers.

6. A method of manufacturing a multi-layer printed circuit board of the type having at least two layers of an electrically conductive medium separated by an electrically non-conductive medium, the two conductive medium layers defining respective predetermined circuit patterns, characterised by printing a first electrically conductive medium layer directly onto a first electrically non-conductive layer in the form of a metal-based fluid, drying the metal-based fluid, the metal-based fluid being chosen such that, on drying it leaves behind a solid metallic residue on said first non-conductive layer defining a first predetermined circuit configuration, applying a second non-conductive layer over said solid metallic residue and printing a second conducting material layer over the second non-conductive layer, whereby, upon drying, said second conductive material layer defines a second predetermined circuit configuration on said second non-conductive layer.

7. A method as claimed in claim 3 or 6, wherein printing is accomplished by forming a photographic negative of a required circuit configuration, producing from the negative a plastics printing plate wherein the pattern of the circuit is in raised relief, applying said conductive metal-based fluid to the plate by way of a roller, transferring the image from the plate to a cylinder covered by a rubber sheet and thence to the non-conductive surface on which the relevant circuit pattern is to be applied.

8. A method as claimed in claim 3, 6 or 7, in which the metal-based fluid comprises flaked and/or powdered metal particles suspended in a mixture of two different varnishes, the varnishes being chosen such that when heat is applied to the fluid, one varnish evaporates and the other oxidises to bind the flaked and/or powdered metal particles into a solid layer.

9. A method as claimed in claim 8, wherein the metal is silver.

. . . . . . . . . . . . . . . . . . . . . . . . . . . . . . . . . . . . . . . . . . . . . . . . . . . . . . . . . . . . . . . . . . .

*Fig_1*

0164921

Fig 2

Fig 3